(19) Europäisches Patentamt
European Patent Office
Office européen des brevets

(11) EP 1 211 292 B1

(12) EUROPEAN PATENT SPECIFICATION

(45) Date of publication and mention of the grant of the patent:
**24.05.2006 Bulletin 2006/21**

(21) Application number: **00937234.3**

(22) Date of filing: **15.06.2000**

(51) Int Cl.:
***C08L 101/00*** (2006.01) ***C08K 3/36*** (2006.01)
***C08K 9/00*** (2006.01) ***H01L 21/205*** (2006.01)
***H01L 21/302*** (2006.01) *C08K 9/00* (2006.01)
*C08K 9/00* (2006.01) *C08K 9/02* (2006.01)
*C08K 9/06* (2006.01)

(86) International application number:
**PCT/JP2000/003877**

(87) International publication number:
**WO 2000/078871 (28.12.2000 Gazette 2000/52)**

# (54) USE OF A CROSSLINKED ELASTOMER COMPOSITION FOR SEALING A SEMICONDUCTOR PRODUCTION APPARATUS

VERWENDUNG EINER VERNETZTEN ELASTOMERENZUSAMMENSETZUNG ZUR VERSIEGELUNG EINER HALBLEITERHERSTELLUNGSVORRICHTUNG

UTILISATION D'UNE RESINE ELASTOMERE RETICULEE POUR SCELLER UN APPAREIL DE FABRICATION DE SEMI-CONDUCTEUR

(84) Designated Contracting States:
**DE FR IT NL**

(30) Priority: **21.06.1999 JP 17462899**

(43) Date of publication of application:
**05.06.2002 Bulletin 2002/23**

(73) Proprietor: **DAIKIN INDUSTRIES, LTD.**
**Osaka-shi, Osaka 530-8323 (JP)**

(72) Inventors:
- **TANAKA, Hiroyuki, Yodogawa-seisakusho, Settsu-shi, Osaka 566-8585 (JP)**
- **HASEGAWA, Masanori, Yodogawa-seisakusho, Settsu-shi, Osaka 566-8585 (JP)**
- **NOGUCHI, Tsuyoshi, Yodogawa-seisakusho, Settsu-shi, Osaka 566-8585 (JP)**
- **HIGASHINO, Katsuhiko, Yodogawa-seisakusho, Settsu-shi, Osaka 566-8585 (JP)**
- **NISHIMURA, Yosuke, Yodogawa-seisakusho Settsu-shi, Osaka 566-8585 (JP)**

(74) Representative: **HOFFMANN EITLE**
**Patent- und Rechtsanwälte**
**Arabellastrasse 4**
**81925 München (DE)**

(56) References cited:

| | |
|---|---|
| WO-A-00/42100 | WO-A-99/60039 |
| JP-A- 6 089 948 | JP-A- 6 136 271 |
| JP-A- 6 302 527 | JP-A- 8 337 680 |
| JP-A- 10 154 777 | US-A- 3 325 440 |
| US-A- 5 498 669 | US-A- 5 665 803 |

- **DATABASE WPI Section Ch, Week 199147 Derwent Publications Ltd., London, GB; Class A14, AN 1991-343673 XP002213080 -& JP 03 229747 A (TOA PAINT CO LTD), 11 October 1991 (1991-10-11)**
- **DATABASE WPI Section Ch, Week 198645 Derwent Publications Ltd., London, GB; Class A12, AN 1986-294560 XP002213081 -& JP 61 215637 A (BRIDGESTONE TIRE KK), 25 September 1986 (1986-09-25)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 211 292 B1

- **DATABASE WPI Section Ch, Week 198652 Derwent Publications Ltd., London, GB; Class A18, AN 1986-342450 XP002213082 -& JP 61 255945 A (BRIDGESTONE TIRE KK), 13 November 1986 (1986-11-13)**
- **DATABASE WPI Section Ch, Week 199917 Derwent Publications Ltd., London, GB; Class A21, AN 1999-199069 XP002213083 -& JP 11 043555 A (TOSHIBA KK), 16 February 1999 (1999-02-16)**


Remarks:

The file contains technical information submitted after the application was filed and not included in this specification

## Description

TECHNICAL FIELD

The present invention relates to the use as a sealing material of a clean crosslinked elastomer composition which contains ultra fine powders of silicon oxide particularly for sealing semiconductor production apparatuses. The sealing material has excellent mechanical strength and ensures a reduction in an amount of impurity gas to be released.

BACKGROUND ART

In producing semiconductor elements, very high cleanliness is required, and the requirements for high cleanliness range over not only management of a production process of semiconductors but also a semiconductor production apparatus and parts thereof. If the parts of semiconductor production apparatuses are cleaned only after being built in the apparatuses, a degree of possible cleanliness is limited. Such parts are required to have been cleaned highly before being built in the apparatuses. In production of semiconductors, there are various contaminations which come from parts of semiconductor production apparatuses, for example, so-called microparticles (impurity fine particles) generated or released from the parts and impurity gases (outgas) generated due to decomposition or modification of materials of the parts and mixed to an atmosphere gas, which have an adverse effect particularly on accurate etching treatment of semiconductor elements.

Also cleanliness is required similarly in a molded article used as a sealing material for semiconductor production apparatuses which the present invention is particularly applied to. The present applicants have attained high cleanliness of the sealing material itself by employing a special method of cleaning the sealing material after molding (JP-A-10-77781, JP-A-10-161988).

Such a sealing material is produced by crosslinking a crosslinkable elastomer composition such as a rubber, and in order to improve mechanical properties such as compression set, there is a case where a metal oxide filler is added to the composition. There is a case where titanium oxide or silica (white carbon) is added as such a filler to enhance whiteness and improve plasma resistance (Japanese Patent Nos. 2858198, 2783576).

In order to clean a molded article such as a sealing material, to which a metal oxide is added as a filler, particularly in order to eliminate impurity metals, the above-mentioned method of washing the sealing material after molding with an acid to extract impurity metals and a method of adding a filler washed with an acid can be considered. In that case, it is necessary to crosslink an elastomer composition after the filler is added thereto. However when such a usual filler obtained by washing with an acid is used, peroxide crosslinking which has been employed commonly as a crosslinking method cannot be carried out. Namely if peroxide crosslinking is intended to be conducted, in some cases, a crosslinking failure arises, which not only leads to lowering of mold-processability but also has an adverse effect on characteristics of a molded article such as compression set, tensile strength and modulus.

Also in a production process of semiconductors, there is a case where a drying step such as plasma ashing is carried out. In that drying step, there is a case where microparticles (impurity fine particles) arise from a molded article produced from an elastomer. Those microparticles as contamination sources also must be eliminated.

Particularly when silica is used, compression set is lowered. To improve it, the above-mentioned Japanese Patent No. 2783576 discloses use of ultra fine particles of white carbon having a pH value of 9 to 12 in 4 to 5 % by weight of aqueous dispersion.

Also in the above-mentioned Japanese Patent No. 2858198, a combination use of silica and carbon black is proposed to reduce an amount of microparticles to be generated in the drying process. The silica proposed therein is a dry silica having an average particle size of 1 to 50 μm, preferably 10 to 40 μm.

As a result of studies which have been made after the above-mentioned proposals, it was found that much amount of dioctyl phthalate (DOP) are present in an outgas which is a problem. DOP has been used in a large amount, for example, as a plasticizer of plastics, and is a compound which is present in a large amount in usual living environment.

In this regard, the composition disclosed in the Japanese Patent No. 2783576 has a problem that DOP is contained in an outgas in a high concentration.

Also the composition disclosed in the Japanese Patent No. 2858198 has an average particle size of as large as 1 to 50 μm, and therefore when generation of microparticles arises, there is a problem that in case of patterning of a standard line width of 0.3 to 0.35 μm in 64 Mbit semiconductor, patterning defect occurs in some cases.

JP-A-11-043555 teaches a sealing material for a semiconductor apparatus formed from a resin composition containing inorganic fillers having a hydroxyl density of up to 1.5 OH/nm$^2$ on the surface together with a resin matrix.

JP-A-63-02527 teaches a sealing material for a semiconductor production apparatus which comprises 1-50 parts by weight of silica and 1-10 parts by weight of an organic peroxide based upon 100 parts by weight of a fluorine elastomer. The material is void-free and contains less than 1 part by weight of metal elements and less than 1 part by weight of carbon black based upon 100 parts by weight of the sealing material.

An object of the present invention is to provide a composition which is excellent in mechanical strength, particularly tensile strength even in case of a crosslinkable elastomer composition containing ultra fine powders of silicon oxide, and offers a reduced amount of outgas (particularly DOP and water) and microparticles.

DISCLOSURE OF INVENTION

Accordingly, the present invention provides the use of sealing material for sealing a semiconductor production apparatus selected from an etching system, a cleaning system, an exposing system, a polishing system, a film forming system or a diffusion and ion implantation system, the sealing material being obtainable by crosslinking a crosslinkable elastomer composition comprising a crosslinkable fluorine-containing elastomer component and ultra fine silicon oxide powder having:

(i) a dioctylphthalate adsorption of not more than 8 μg per 1 g of silicon oxide,
(ii) an average particle size of not more than 0.5 μm, and
(iii) 100 x $10^{19}$ or less hydroxyl groups per gram on the powder surface; said sealing material generating not more than 1 ppb of dioctylphthalate gas when heated at 200°C for 15 minutes.

Preferably the average size of the particles of the silicon oxide is from 0.01 to 0.03 μm.
An amount of hydroxyl groups which are present on the surfaces of ultra fine silicon oxide powder can be calculated from an amount of dehydration when heated at high temperature by the method mentioned hereinbelow.
It is preferable that the composition of the present invention contains 1 to 150 parts by weight (hereinafter referred to as "part") of the ultra fine powders of silicon oxide on the basis of 100 parts of the crosslinkable elastomer component. Also the composition can contain 0.05 to 10 parts of an organic peroxide, 0.1 to 10 parts of a crosslinking aid and 1 to 150 parts of the ultra fine powders of silicon oxide on the basis of 100 parts of the crosslinkable elastomer component.
Examples of the preferred crosslinkable elastomer component are fluorine-containing elastomers, particularly perfluoro type elastomers.

BEST MODE FOR CARRYING OUT THE INVENTION

The ultra fine powders of silicon oxide which are used in the present invention have 100 x $10^{19}$ or less, preferably 90 x $10^{19}$ or less, further preferably 80 x $10^{19}$ or less hydroxyl groups per gram on the surfaces thereof. When an amount of hydroxyl groups on the surfaces of ultra fine powders of silicon oxide is small, adsorption of water and DOP in the air can be reduced, and generation of steam and DOP which become an outgas can be decreased when the composition is processed into a molded article and used as parts of semiconductor production apparatuses.
As the ultra fine powders of silicon oxide which have a low content of hydroxyl groups and a small amount of DOP adsorption, ultra fine powders of silica or ultra fine powders of synthetic quartz silica are used as they are or can be used after surface-treated with hydrofluoric acid or silane coupling agent.
Or ultra fine powders of silica or ultra fine powders of synthetic quartz silica are used after heat-treated at high temperature of not less than 400°C in an inert gas stream.
As the ultra fine powders of silica, there are dry silica, fumed silica and wet silica. In the present invention, dry silica or fumed silica is preferred from a point that an amount of outgas to be generated is small.
Examples of the ultra fine powders of synthetic quartz silica are, for instance, molten quartz silica, synthetic quartz silica, crystalline quartz silica, and the like.
The ultra fine powders of silica or synthetic quartz silica may be in either of irregular or spherical form.
The treatment with hydrofluoric acid may be carried out, for example, by dipping in 0.01 % dilute hydrofluoric acid for about 30 minutes, washing with ultra pure water and then drying in an inert gas containing no organic substance such as nitrogen gas.
Also the surface treatment with a silane coupling agent may be carried out through usual method. Examples of the preferred silane coupling agent are, for instance, vinyl silanes such as vinyltrimethoxysilane and vinyltriethoxysilane, amino silanes such as N-(2-aminoethyl)-3-aminopropylmethyldimethoxysilane and N-(2-aminoethyl)-3-aminopropyltrimethoxysilane, 3-glycidoxypropyltrimethoxysilane, methacryloxypropyltrimethoxysilane, 3-mercaptopropyltrimethoxysilane, dimethyldichlorosilane, and the like. Particularly when peroxide crosslinking is carried out, treatment with a vinyl silane type silane coupling agent is preferred from the viewpoint of high reinforcing property and less releasing as microparticles.
The heat treatment at high temperature is carried out in an inert gas stream at a temperature of not less than 400°C, preferably 400° to 1,500°C, further preferably 500° to 1,200°C. By such heat treatment, thermal decomposition of hydroxyl groups being inherently present on surfaces of ultra fine powders of silica occurs and the number of hydroxyl

groups are reduced remarkably and thus water adsorbing points can be decreased. As a result, an amount of water in the outgas can be reduced. At a temperature lower than 400°C, though it is possible to remove water already adsorbed, it is difficult to further carry out thermal decomposition of hydroxyl groups on the surfaces of ultra fine powders of silica. Heat treating time is from 30 to 240 minutes, usually from 30 to 180 minutes. A flow rate of the inert gas is not limited particularly, and may be usually from 0.1 to 20 liter/min. Examples of the inert gas are nitrogen gas, helium gas, argon gas, and the like.

An average particle size of the ultra fine powders of silicone oxide of the present invention is not more than 0.5 μm, preferably from 0.01 to 0.4 μm. Hitherto fine particles having a particle size of not less than 1 μm have been used as disclosed in the above-mentioned Japanese Patent No. 2858198. That is because as the particle size decreases, handling property of not only the ultra fine powders but also the crosslinkable composition is lowered. In the present invention, handling property (kneading property, etc.) of the crosslinkable elastomer composition is not lowered.

Particularly when ultra fine powders having an average particle size of from about 0.01 μm to about 0.05 μm are used, even in case where a pattern of 0.2 μm distance between the patterning lines (line width) is drawn on semiconductor element, no connection of lines occurs (no plugging occurs between the lines).

It is preferable to adjust a pH value of the ultra fine powders of silicon oxide to be acid or neutral (pH: not less than 3.0 and less than 9.0), particularly to be acid (pH: from 3.0 to 6.0) to reduce a density of hydroxyl groups on the surfaces thereof. In that point, since the silica used for the composition disclosed in the above-mentioned Japanese Patent No. 2783576 has a pH value of as high as not less than 9 and has a lot of hydroxyl groups on the surfaces thereof, it can be considered that DOP is easily adsorbed to the silica and as a result of it, released into an outgas in high concentration.

It is preferable that the content of impurity metals other than silicon in the ultra fine powders of silicon oxide is adjusted to not more than 10 ppm, preferably not more than 5 ppm.

Examples of the crosslinkable fluorine-containing elastomer are, for instance, those mentioned below.

A perfluoro elastomer comprising 40 to 90 % by mole of tetrafluoroethylene, 10 to 60 % by mole of perfluorovinylether represented by the formula (1);

$$CF_2{=}CF\text{-}OR_f$$

wherein $R_f$ is a perfluoroalkyl group having 1 to 5 carbon atoms or a perfluoroalkyl(poly)ether group having 3 to 12 carbon atoms and 1 to 3 oxygen atoms, and 0 to 5 % by mole of monomer giving a curing site.

A vinylidene fluoride elastomer comprising 30 to 90 % by mole of vinylidene fluoride, 15 to 40 % by mole of hexafluoropropylene and 0 to 30 % by mole of tetrafluoroethylene.

A thermoplastic perfluoro elastomer which is a fluorine-containing multi-segment polymer comprising an elastomeric fluorine-containing polymer chain segment and a non-elastomeric fluorine-containing polymer chain segment, in which the elastomeric fluorine-containing polymer chain segment comprises 40 to 90 % by mole of tetrafluoroethylene, 10 to 60 % by mole of perfluorovinylether represented by the formula (1);

$$CF_2{=}CF\text{-}OR_f$$

wherein $R_f$ is a perfluoroalkyl group having 1 to 5 carbon atoms or a perfluoroalkyl(poly)ether group having 3 to 12 carbon atoms and 1 to 3 oxygen atoms, and 0 to 5 % by mole of monomer giving a curing site, and the non-elastomeric fluorine-containing polymer chain segment comprises 85 to 100 % by mole of tetrafluoroethylene and 0 to 15 % by mole of the formula (2);

$$CF_2{=}CF\text{-}OR^1$$

wherein $R_f^1$ is $CF_3$ or $OR_f^2$, in which $R_f^2$ is a perfluoroalkyl group having 1 to 5 carbon atoms.

A thermoplastic non-perfluoro elastomer which is a fluorine-containing multi-segment polymer comprising an elastomeric fluorine-containing polymer chain segment and a non-elastomeric fluorine-containing polymer chain segment, in which the elastomeric fluorine-containing polymer chain segment contains recurring units derived from 45 to 85 % by mole of vinylidene fluoride and from at least one other monomer copolymerizable with vinylidene fluoride, respectively. Examples of the other monomer are hexafluoropropylene, tetrafluoroethylene, chlorotrifluoroethylene, trifluoroethylene, trifluoropropylene, tetrafluoropropylene, pentafluoropropylene, trifluorobutene, tetrafluoroisobutene, perfluoro(alkyl vinyl ether), vinyl fluoride, ethylene, propylene, alkylvinylether, and the like.

A fluorine-containing elastomer having cold resistance which is obtained by radical polymerization in the presence of a diiodine compound and comprises 0.005 to 1.5 % by mole of fluorinated vinyl ether unit having iodine, 40 to 90 % by mole of vinylidene fluoride unit and 3 to 35 % by mole of perfluoro(methyl vinyl ether), in which as case demands, up to 25 % by mole of hexafluoropropylene unit and/or up to 40 % by mole of tetrafluoroethylene unit may be contained therein

(JP-A-8-15753).

A copolymer of tetrafluoroethylene and propylene (USP 3467635).

The elastomer composition is crosslinked and molded into a desired form of sealing material. Crosslinking is generally carried out by peroxide crosslinking. Also other known crosslinking methods are employed, for example, a triazine crosslinking system, in which a nitrile group is introduced as a crosslinking point into a fluorine-containing elastomer and a triazine ring is formed by using an organotin compound (for example, cf. JP-A-58-152041), an oxazole crosslinking system, in which a nitrile group is introduced similarly as a crosslinking point into a fluorine-containing elastomer and an oxazole ring is formed by using bisaminophenol (for example, cf. JP-A-59-109546), an imidazole crosslinking system, in which an imidazole ring is formed by using a tetraamine compound (for example, cf. JP-A-59-109546), a thiazole crosslinking system, in which a thiazole ring is formed by using bisaminothiophenol (for example, cf. JP-A-8-104789), and the like. Further radiation crosslinking method and electron beam crosslinking method may be employed.

Examples of a crosslinking agent used for oxazole crosslinking system, imidazole crosslinking system and thiazole crosslinking system are, for instance, a bisaminothiophenol crosslinking agent, bisaminophenol crosslinking agent and bisdiaminophenyl crosslinking agent represented by the formula (3):

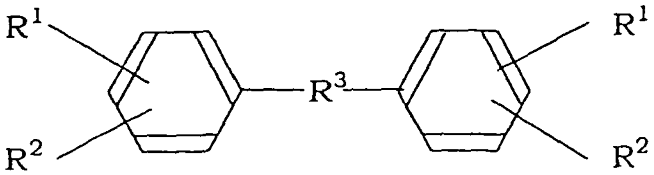

(3)

wherein $R^3$ is $-SO_2-$, -O-, -CO-, an alkylene group having 1 to 6 carbon atoms, a perfluoroalkylene group having 1 to 10 carbon atoms or a single bond, one of $R^1$ and $R^2$ is $-NH_2$ and another one is $-NH_2$, -OH or -SH, preferably both of $R^1$ and $R^2$ are $-NH_2$, bisamidorazone crosslinking agent represented by the formula (4):

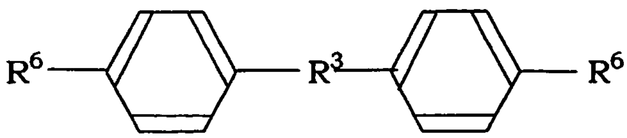

**(4)**

in which $R^3$ is as defined above, $R^6$ is

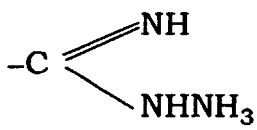

or

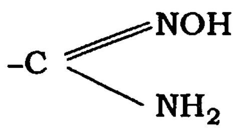

,

and bisamidoxime crosslinking agent represented by the formula (5) or (6)

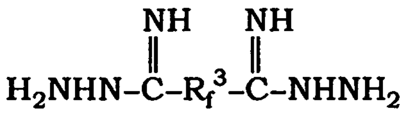

**(5)**

in which $R_f^3$ is a perfluoroalkylene group having 1 to 10 carbon atoms,

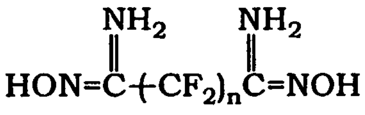

(6)

in which n is an integer of 1 to 10. Those bisaminophenol crosslinking agent, bisaminothiophenol crosslinking agent and bisdiaminophenyl crosslinking agent have been used for a crosslinking system wherein a nitrile group is used as a crosslinking point. Further since they also react with carboxyl group and alkoxycarbonyl group, an oxazole ring, thiazole ring and imidazole ring are also formed in crosslinking systems having those functional groups as the crosslinking points and thus a crosslinked product can be given.

Examples of the particularly preferred crosslinking agent are compounds having a plurality of 3-amino-4-hydroxyphenyl groups, 3-amino-4-mercaptophenyl groups or 3,4-diaminophenyl groups represented by the formula (7):

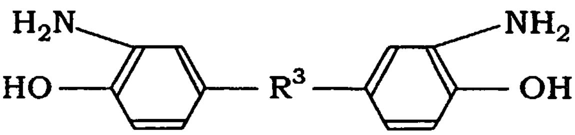

(7)

in which $R^3$ is as defined above. Concrete examples thereof are, for instance, 2,2-bis(3-amino-4-hydroxyphenyl)hexafluoropropane (general term: bis(aminophenol)AF), 2,2-bis(3-amino-4-mercaptophenyl)hexafluoropropane, tetraaminobenzene, bis-3,4-diaminophenylmethane, bis-3,4-diaminophenylether, 2,2-bis(3,4-diaminophenyl)hexafluoropropane, and the like.

An adding amount of the crosslinking agent is preferably from 0.1 to 10 parts on the basis of 100 parts of the elastomer.

When carrying out peroxide crosslinking, any of known organic peroxides which generate a peroxy radical under vulcanizing temperature condition may be used. Examples of the preferred organic peroxide are di-t-butyl peroxide, dicumyl peroxide, 2,5-dimethyl-2,5-di(benzoylperoxy)hexane, 2,5-dimethyl-2,5-di(t-butylperoxy)hexane, 1,1-bis(t-butylperoxy)-3,5,5-trimethylcyclohexane, 2,5-dimethylhexane-2,5-dihydroxy peroxide, t-butylcumyl peroxide, α,α'-bis(t-butylperoxy)-p-diisopropylbenzene, 2,5-dimethyl-2,5-di(t-butylperoxy)hexyne-3, benzoyl peroxide, t-butylperoxybenzene, t-butylperoxymaleate, t-butylperoxyisopropyl carbonate, and the like.

A content of the organic peroxide is usually from 0.05 to 10 parts, preferably from 1 to 5 parts on the basis of 100 parts of the fluorine-containing elastomer.

When the content of the organic peroxide is less than 0.05 part, the fluorine-containing elastomer is not crosslinked sufficiently, and when more than 10 parts, physical properties of the crosslinked product are lowered.

In such peroxide crosslinking, a crosslinking aid such as a polyfunctional co-crosslinking agent can be used. As the polyfunctional co-crosslinking agent, those which are used together with an organic peroxide in peroxide crosslinking of a fluorine-containing elastomer can be used. For example, there are bisolefins represented by triallylcyanurate, trimethallylisocyanurate, triallylisocyanurate, triallylformal, triallylphosphate, triallyltrimellitate, N,N'-m-phenylenebismaleimide, dipropargylterephthalate, diallylphthalate, tetraallylterephthalamide, tris(diallylamine)-s-triazine, triallylphosphite, N,N-diallylacrylamide and 1,6-divinyldodecafluorohexane.

Also suitable are fluorine-containing triallylisocyanurate prepared by replacing a part of hydrogen atoms in three allyl groups of triallylisocyanurate with fluorine atoms having higher heat resistance, and the like (cf. USP 4320216, WO98/00407, Klenovich, S.V. et al, Zh. Prikl, Khim. (Leningrad) (1987, 60(3), 656-8)).

A content of the crosslinking aid is usually from 0.1 to 10 parts, preferably from 0.5 to 5 parts on the basis of 100 parts of the fluorine-containing elastomer.

In addition, a processing aid, internal mold releasing agent, and the like may be added. Peroxide crosslinking can be carried out by usual method, and no crosslinking failure recognized in conventional method arises.

The molded article of the present invention is cleaned significantly highly by treating, for example, through a special cleaning method disclosed in the above-mentioned JP-A-10-77781, namely a method of washing with ultra-pure water, a method of washing with a clean organic compound in the form of liquid at a washing temperature or inorganic aqueous solution, a method of cleaning by dry etching or a method of extraction cleaning, and thus the molded article for use as a sealing material for semiconductor production apparatuses which ensures less releasing of an outgas and is excellent in plasma resistance can be obtained.

The molded sealing material for use in the present invention ensures less releasing of an outgas, and particularly generation of DOP when heating at 200°C for 15 minutes can be reduced to not more than 3 ppb, further not more than

1 ppb.

The sealing material is used for sealing of semiconductor production apparatuses in which high cleanliness is demanded. Examples of the sealing material are O-ring, square ring, gasket, packing, oil seal, bearing seal, lip seal, and the like.

In the present invention, the semiconductor production apparatuses are as follows.

(1) Etching system

- Dry etching equipment
  - Plasma etching machine
  - Reactive ion etching machine
  - Reactive ion beam etching machine
  - Sputter etching machine
  - Ion beam etching machine
- Wet etching equipment
- Ashing equipment

(2) Cleaning system

- Dry etching cleaning equipment
  - $UV/O_3$ cleaning machine
  - Ion beam cleaning machine
  - Laser beam cleaning machine
  - Plasma cleaning machine
  - Gas etching cleaning machine
- Extractive cleaning equipment
  - Soxhlet extractive cleaning machine
  - High temperature high pressure extractive cleaning machine
  - Microwave extractive cleaning machine
  - Supercritical extractive cleaning machine

(3) Exposing system

- Stepper
- Coater and developer

(4) Polishing system

- CMP equipment

(5) Film forming system

- CVD equipment
- Sputtering equipment

(6) Diffusion and ion implantation system

- Oxidation and diffusion equipment
- Ion implantation equipment

The present invention is then explained by means of examples, but is not limited to them.

**EXAMPLE 1**

The elastomer composition of the present invention was prepared by kneading 10 g of ultra fine powders of dry amorphous silica (REOLOSIL QS-10 available from Kabushiki Kaisha Tokuyama, specific surface area: 140 $m^2$/g, average particle size: 0.02 $\mu$m), 1.0 g of PERHEXA 2.5B (available from NOF Corporation) and 3.0 g of triallylisocyanurate (TAIC) with 100 g of tetrafluoroethylene/perfluoro(alkyl vinyl ether) copolymer elastomer. The density of hydroxyl groups on the surfaces of ultra fine particles of silicon oxide, DOP adsorption and contents of impurity metals were determined by the methods mentioned below. The results are shown in Table 1.

(Density of surface hydroxyl groups)

The ultra fine powders of silicon oxide are pre-treated by heating at 150°C for one hour to remove water absorbed in the air. Those pre-treated ultra fine particles of silicon oxide are measured by an amount of 5 g and further heated at 1,200° to 1,500°C until a weight reduction stops. Then an amount of the weight reduction is measured.

An amount of hydroxyl groups which are present on the surface (Density of surface hydroxyl groups: Number of hydroxyl groups/g) is calculated based on the results of measurement of weight reduction by the following equation.

$$\text{Density of surface hydroxyl groups (Number of hydroxyl groups/g)} = (\text{Amount of weight reduction } (\mu g/g) \div (\text{Molecular weight of water} \times 10^6)) \times \text{Avogadro number} \times 2$$

(DOP adsorption)

Ultra fine powders of silicon oxide are added to DOP solution diluted with acetone, and after allowed to stand at room temperature for 15 minutes, the solution is heated at 60°C for 15 minutes to evaporate acetone. Thus the ultra fine powders of silicon oxide contaminated forcedly with DOP are prepared. Those ultra fine powders of silicon oxide contaminated forcedly with DOP are put in a glass tube. After sealed, the tube is heated at 200°C for 15 minutes, and then generated gas is collected in a cooled trap tube. The trapped substance is rapidly heated and analyzed with a gas chromatograph (GC-14A available from Shimadzu Corporation, Column: UA-15 available from Shimadzu Corporation). An amount of DOP released from the ultra fine particles of silicon oxide is calculated from a peak area of the obtained chart.

By using the results of the calculation, an amount of DOP which can be adsorbed by individual particles of ultra fine powders of silicon oxide is calculated (an amount of DOP adsorbed strongly on the ultra fine powders of silicon oxide).

$$\text{Amount of DOP which can be adsorbed } (\mu g/g) = \text{Amount of DOP forcedly adsorbed } (\mu g/g) - \text{Amount of released DOP } (\mu g/g)$$

(Weight reduction by heating at 200°C)

1.0 Gram of ultra fine powders of silicon oxide is put in an aluminum vessel and heated at 200°C until a change in weight reduction stops (usually about two hours). A weight reduction per unit surface area (% by weight/$m^2$) by heating at 200°C is calculated from a change in weight after the heating by using the following equation.

$$\text{Weight reduction per unit surface area by heating (\% by weight/m}^2\text{)} = \frac{\text{Weight before heating (g)} - \text{Weight after heating (g)}}{\text{Weight before heating (g)}} \div \text{Specific surface area (m}^2\text{/g)}$$

(Contents of impurity metals)

0.1 Gram of ultra fine powders of silicon oxide is put in a platinum crucible, and after diffused and melted in 5 ml of 50 % hydrofluoric acid in a hot bath, is diluted with ultra pure water. Contents of metals of that solution are determined through atomic absorption analysis by using an atomic absorption photometer (Z8000 available from Hitachi, Ltd.). Metals intended to detect are Na, K and Cu. The metal content in the filler is determined by the following equation.

$$\text{Metal content (ppm by weight)} = \frac{\text{Concentration in solution (ppm by weight)}}{\text{Weight of filler (g)}} \times \text{Weight of solution (g)}$$

The density of surface hydroxyl groups, DOP adsorption and contents of impurity metals of ultra fine powders of silicon oxide used in Examples 2 to 4 and Comparative Examples 1 to 2 are also shown in Table 1.
The ultra fine powders of silicon oxide in Table 1 are as follows.

REOLOSIL QS-10:

Ultra fine powders of amorphous silica available from Kabushiki Kaisha Tokuyama

REOLOSIL QS-40:

Ultra fine powders of amorphous silica available from Kabushiki Kaisha Tokuyama

REOLOSIL DM-10:

Ultra fine powders of amorphous silica available from Kabushiki Kaisha Tokuyama

Cab-O-Sil M-7D:

Ultra fine powders of fumed silica available from Cabot Specialty Chemicals, Inc.

1-FX:

Ultra fine powders of synthetic quartz silica available from Kabushiki Kaisha Tatsumori

TABLE 1

| | Ex. 1 | Ex. 2 | Ex. 3 | Ex. 4 | Ex. 5 | Com. Ex. 1 | Com. Ex. 2 |
|---|---|---|---|---|---|---|---|
| Ultra fine powders of silicon oxide | REOLOSIL QS-10 | REOLOSIL DM-10 | Cab-O-Sil M-7D | Cab-O-Sil M-7D (heat-treated) | 1-FX treated with vinyl silane | REOLOSIL QS-40 | 1-FX |
| Density of surface hydroxyl groups (No. of groups/g) | $70 \times 10^{19}$ | $6 \times 10^{19}$ | $1 \times 10^{14}$ | $1 \times 10^{7}$ | $3 \times 10^{19}$ | $190 \times 10^{19}$ | $150 \times 10^{19}$ |
| DOP absorption (μg/g) | 1.9 | 0.8 | 0.0 | 0.0 | 0.6 | 14.2 | 8.1 |
| Weight reduction by heating at 200°C (% by weight/$m^2$) | 5.0 | 4.0 | 3.0 | 0.1 | 4.0 | 10.0 | 9.0 |
| Average particle size (μm) | 0.02 | 0.03 | 0.02 | 0.02 | 0.38 | 0.01 | 0.38 |
| Contents of impurity metals (ppm by weight) | | | | | | | |
| Na | 0.5 | 0.02 | 2.0 | 2.0 | 0.07 | 0.3 | 0.2 |
| K | 0.05 | 0.01 | 0.1 | 0.1 | 0.01 | 0.04 | 0.03 |
| Ca | 0.1 | 0.08 | 0.5 | 0.5 | 0.02 | 0.2 | 0.04 |
| Fe | 0.3 | 0.3 | 0.2 | 0.2 | 0.1 | 0.3 | 0.05 |
| Ni | 0.005 | 0.0 | 0.09 | 0.09 | 0.0 | 0.02 | 0.0 |
| Cu | 0.0 | 0.0 | 0.01 | 0.01 | 0.003 | 0.0 | 0.0 |
| Cr | 0.02 | 0.01 | 0.04 | 0.04 | 0.0 | 0.05 | 0.0 |
| Mg | 0.007 | 0.01 | 0.01 | 0.01 | 0.0 | 0.01 | 0.002 |
| Zn | 0.07 | 0.06 | 0.1 | 0.1 | 0.03 | 0.06 | 0.05 |

The elastomer composition was subjected to press-crosslinking (primary crosslinking) at 160°C for 10 minutes and then crosslinking (secondary crosslinking) in an oven at 180°C for four hours to give an O-ring (AS-568A-214). Also a vulcanization curve of the composition at 160°C was determined with JSR Curastometer Model II (available from Nichigo Shoji Kabushiki Kaisha), and a minimum viscosity (ML), degree of vulcanization (MH), induction time (T10) and optimum vulcanizing time (T90) were obtained. Further handling property of the composition was determined in the manner mentioned below. The results are shown in Table 2.

(Processability)

Easiness of handling in the range of from kneading step to crosslinking step of the crosslinkable elastomer composition, for example, easy winding onto a roll and easy cutting at kneading and flowability of the elastomer at crosslinking is synthetically evaluated with naked eyes.
Evaluation was made with naked eyes under the following criteria.

A: No defects are found, and processing is carried out smoothly.

B: Almost no defect is found. Time and labor are required somewhat particularly at the kneading step.

C: Much time and labor are required in the steps from the kneading step to the crosslinking step, but processing can be finished somehow.

D: Processing cannot be carried out unless the processing conditions are made strict considerably.

Mechanical properties and an amount of released DOP of the O-ring were measured as follows. The results are shown in Table 2.

(Mechanical properties)

Physical properties in normal state and compression set (200°C, 70 hours, compression by 25 %) were measured according to JIS K 6301.

(Amount of released DOP gas)

The O-ring (AS568A-214) is put in a glass tube. After sealed, the tube is heated at 200°C for 15 minutes, and then generated gas is collected in a cooled trap tube. The trapped substance is rapidly heated and analyzed with a gas chromatograph (GC-14A available from Shimadzu Corporation, Column: UA-15 available from Shimadzu Corporation). An amount of DOP released from the O-ring is calculated from a peak area of the obtained chart.

(Amount of water generation)

An O-ring (AS568A-214) is put in a glass tube. After sealed, the tube is heated at 200°C for 30 minutes, and then an amount of generated water is measured with Karl Fischer type water meter (available from Hiranuma Sangyo Kabushiki Kaisha).

**EXAMPLE 2**

A crosslinkable elastomer composition was prepared in the same manner as in Example 1 except that ultra fine powders of dry amorphous silica (REOLOSIL DM-10 available from Kabushiki Kaisha Tokuyama, specific surface area: 120 $m^2$/g, average particle size: 0.03 μm) surface-treated with monomethyltrichlorosilane (silane coupling agent) were used instead of the dry amorphous silica of Example 1. Further the composition was molded into O-ring in the same manner as in Example 1. With respect to those composition and molded article, various characteristics thereof were measured in the same manner as in Example 1. The results are shown in Table 2.

**EXAMPLE 3**

A crosslinkable elastomer composition was prepared in the same manner as in Example 1 except that ultra fine powders of fumed silica (Cab-O-Sil M-7D (compression molding grade) available from Cabot Specialty Chemicals, Inc., specific surface area: 200 $m^2$/g, average particle size: 0.02 μm) were used instead of the amorphous silica. Further the composition was molded into O-ring in the same manner as in Example 1. With respect to those composition and molded article, various characteristics thereof were measured in the same manner as in Example 1. The results are shown in Table 2.

**EXAMPLE 4**

A crosslinkable elastomer composition was prepared in the same manner as in Example 1 except that ultra fine powders of fumed silica (Cab-O-Sil M-7D (compression molding grade) available from Cabot Specialty Chemicals, Inc., specific surface area: 200 $m^2$/g, average particle size: 0.02 μm) which had been subjected to heating at 600°C in a nitrogen stream for two hours and then allowing to stand for cooling down to room temperature in a nitrogen stream were used instead of the amorphous silica. Further the composition was molded into O-ring in the same manner as in Example 1. With respect to those composition and molded article, various characteristics thereof were measured in the same manner as in Example 1. The results are shown in Table 2.

**COMPARATIVE EXAMPLE 1**

A crosslinkable elastomer composition was prepared in the same manner as in Example 1 except that ultra fine powders of dry amorphous silica having many hydroxyl groups on the surfaces thereof (REOLOSIL QS-40 available

from Kabushiki Kaisha Tokuyama, specific surface area: 380 $m^2$/g, average particle size: 0.01 μm) were used as the dry amorphous silica. Further the composition was molded into O-ring in the same manner as in Example 1. With respect to those composition and molded article, various characteristics thereof were measured in the same manner as in Example 1. The results are shown in Table 2.

**EXAMPLE 5**

A crosslinkable elastomer composition was prepared in the same manner as in Example 1 except that ultra fine powders of spherical synthetic quartz silica (1-FX treated with vinyl silane available from Kabushiki Kaisha Tatsumori, specific surface area: 29.7 $m^2$/g, average particle size: 0.38 μm) surface-treated with a vinyl silane coupling agent were used instead of the dry amorphous silica. Further the composition was molded into O-ring in the same manner as in Example 1. With respect to those composition and molded article, various characteristics thereof were measured in the same manner as in Example 1. The results are shown in Table 2.

**COMPARATIVE EXAMPLE 2**

A crosslinkable elastomer composition was prepared in the same manner as in Example 5 except that ultra fine powders of spherical quartz silica (1-FX available from Kabushiki Kaisha Tatsumori, specific surface area: 29.7 $m^2$/g, average particle size: 0.38 μm) which had not been surface-treated with a silane coupling agent were used instead of the ultra fine powders of spherical synthetic quartz silica of Example 5 surface-treated with a silane coupling agent. Further the composition was molded into O-ring in the same manner as in Example 1. With respect to those composition and molded article, various characteristics thereof were measured in the same manner as in Example 1. The results are shown in Table 2.

TABLE 2

| | | Ex. 1 | Ex. 2 | Ex. 3 | Ex. 4 | Com.Ex1 | Ex. 5 | Com. Ex. 2 |
|---|---|---|---|---|---|---|---|---|
| Components (part by weight) | | | | | | | | |
| | Crosslinkable elastomer | 100 | 100 | 100 | 100 | 100 | 100 | 100 |
| | Crosslinking agent | 3 | 3 | 3 | 3 | 3 | 3 | 3 |
| | Crosslinking aid | 1 | 1 | 1 | 1 | 1 | 1 | 1 |
| | Ultra fine powders of silicon oxide | 10 | 10 | 10 | 10 | 10 | 10 | 10 |
| Processability | | A | A | A | A | A | B | B |
| Vulcanization characteristics | | | | | | | | |
| | ML (kg·f) | 0.31 | 0.18 | 0.32 | 0.32 | 0.45 | 0.1 | 0.11 |
| | MH (kg·f) | 8.4 | 8.2 | 8.15 | 8.15 | 8.85 | 6.25 | 5081 |
| | T 10 (min) | 0.6 | 0.5 | 0.5 | 0.5 | 0.5 | 0.7 | 0.7 |
| | T90 (min) | 1.3 | 1.4 | 1.2 | 1.2 | 1 | 1.3 | 1.2 |
| Physical properties in normal state | | | | | | | | |
| | M100 (kg·f) | 124 | 107 | 128 | 128 | 153 | 101 | 79 |
| | Tensile strength (kg·f) | 220 | 212 | 233 | 233 | 213 | 182 | 170 |
| | Elongation (%) | 135 | 148 | 138 | 138 | 127 | 125 | 155 |
| | Hardness (JIS A) | 80 | 80 | 80 | 80 | 82 | 71 | 74 |
| Compression set | | 17 | 16 | 11 | 11 | 17 | 12 | 12 |
| Amount of released DOP (ppb) | | 0.92 | 0.41 | 0.00 | 0.00 | 7.00 | 0.31 | 3.95 |
| Amount of generated water (ppm) | | 500 | 450 | 388 | 180 | 450 | 1000 | 900 |

**EXAMPLE 6**

(Plasma resistance: Weight reduction)

The O-rings (AS-568A-214) produced, respectively in Examples 1 to 4, Comparative Example 1, Example 5 and Comparative Example 2 were put in petri dishes made of glass and then heated at 150°C for 60 minutes in nitrogen atmosphere to give samples.

Those samples were subjected to treating by plasma irradiation under the following conditions, and a weight reduction (% by weight) after the irradiation was measured to determine a change in weight. The results are shown in Table 3.

Plasma irradiation device used:

PX-1000 available from Kabushiki Kaisha Samco International Kenkyusho

Irradiation conditions:

Oxygen ($O_2$) plasma irradiation treatment

Gas flow: 200 sccm
RF output: 400 W
Pressure: 300 mTorr
Etching time: 1 hr, 2 hr, 3 hr
Frequency: 13.56 MHz

$CF_4$ plasma irradiation treatment

Gas flow: 200 sccm
RF output: 400 W
Pressure: 300 mTorr
Etching time: 1 hr, 2 hr, 3 hr
Frequency: 13.56 MHz

Irradiation method:

In order to stabilize an atmosphere in a chamber of the plasma irradiation device, gas replacement is carried out for five minutes with empty chamber for pre-treatment of the chamber. Then the petri dish having the sample therein is placed at the center between the RF electrodes, and the irradiation is carried out under the above-mentioned conditions.

Measurement of weight:

A weight is measured up to two decimal places by using an electronic analyzing balance 2006MPE available from Sartorius GMBH and rounded to one decimal place.

Three samples are used for each kind and evaluation is made with an average thereof.

TABLE 3

Weight reduction (% by weight)

| | Oxygen plasma | | | $CF_4$ plasma | | |
|---|---|---|---|---|---|---|
| | Irradiation time (hr) | | | Irradiation time (hr) | | |
| | 1 | 2 | 3 | 1 | 2 | 3 |
| Com. Ex. 1 | 0.25 | 0.33 | 0.39 | 0.13 | 0.23 | 0.32 |
| Ex. 1 | 0.21 | 0.28 | 0.33 | 0.12 | 0.21 | 0.30 |
| Ex. 2 | 0.18 | 0.24 | 0.28 | 0.10 | 0.18 | 0.24 |
| Ex. 3 | 0.21 | 0.29 | 0.36 | 0.12 | 0.23 | 0.29 |

Table continued

Weight reduction (% by weight)

| | Oxygen plasma | | | $CF_4$ plasma | | |
|---|---|---|---|---|---|---|
| | Irradiation time (hr) | | | Irradiation time (hr) | | |
| | 1 | 2 | 3 | 1 | 2 | 3 |
| Ex. 4 | 0.21 | 0.29 | 0.36 | 0.12 | 0.23 | 0.29 |
| Com. Ex. 2 | 0.23 | 0.32 | 0.40 | 0.12 | 0.18 | 0.26 |
| Ex. 5 | 0.22 | 0.33 | 0.41 | 0.10 | 0.17 | 0.24 |

**EXAMPLE 7**

(Plasma resistance: Number of microparticles generated)

Plasma resistance (Number of microparticles generated) of the O-rings (AS-568A-214) produced, respectively in Examples 1 to 4, Comparative Example 1, Example 5 and Comparative Example 2 was determined by the method mentioned below. The results are shown in Table 4.

(Plasma resistance test: Number of microparticles generated)

Oxygen plasma or $CF_4$ plasma was generated under the conditions of a vacuum pressure of 50 mTorr, an oxygen flow or $CF_4$ flow of 200 cc/min, electric power of 400 W and a frequency of 13.56 MHz by using Plasma Dry Cleaner Model PX-1000 available from Kabushiki Kaisha Samco International Kenkyusho, and the generated oxygen plasma or $CF_4$ plasma was irradiated to the samples (O-ring) under the reactive ion etching (RIE) conditions for three hours. After the irradiation, a supersonic wave was applied to the samples in ultra pure water at 25°C for one hour to take out free microparticles in water, and then the number of microparticles (per liter) having a particle size of not less than 0.2 $\mu$m was measured by a fine particle meter method (a method of emitting light to ultra pure water containing microparticles which was flowed into a sensor part and then electrically measuring amounts of transmitted light and scattered light with a submerged microparticle counter). In Table 4, values converted to the number of microparticles per unit area ($cm^2$) of the O-ring are also shown in the parentheses.

TABLE 4

Number of microparticles generated (x $10^4$/liter)

| Sample | Before irradiation | After one hour irradiation of oxygen plasma | After one hour irradiation of $CF_4$ plasma |
|---|---|---|---|
| Com. Ex. 1 | 7.6 | 32.9 (25.3) | 11.3 (3.7) |
| Ex. 1 | 5.2 | 30.9 (25.7) | 21.7 (16.5) |
| Ex. 2 | 8.4 | 24.6 (16.2) | 46.3 (37.9) |
| Ex. 3 | 8.6 | 13.2 (4.6) | 8.5 (0) |
| Ex. 4 | 8.6 | 13.2 (4.6) | 8.5 (0) |
| Com. Ex. 2 | 5.4 | 47.2 (41.8) | 48.5 (43.1) |
| Ex. 5 | 5.4 | 47.7 (42.3) | 29.3 (23.9) |

INDUSTRIAL APPLICABILITY

The crosslinkable elastomer composition for use in the present invention which comprises ultra fine powders of silicon oxide having a small density of surface hydroxyl groups and less adsorbing DOP is excellent in mechanical properties, and an amount of outgas is small and thus the composition is suitable as a very clean material for molded article for semiconductor production apparatuses.

## Claims

1. Use of a sealing material for sealing a semiconductor production apparatus selected from an etching system, a cleaning system, an exposing system, a polishing system, a film forming system or a diffusion and ion implantation system, the sealing material being obtainable by crosslinking a crosslinkable elastomer composition comprising a crosslinkable fluorine-containing elastomer component and ultra fine silicon oxide powder having:

   (i) a dioctylphthalate adsorption of not more than 8 μg per 1 g of silicon oxide,
   (ii) an average particle size of not more than 0.5 μm, and
   (iii) 100 x $10^{19}$ or less hydroxyl groups per gram on the powder surface;

   said sealing material generating not more than 1 ppb of dioctylphthalate gas when heated at 200°C for 15 minutes.

2. The use according to Claim 1, wherein the average particle size of the ultra fine silicon oxide powder is from 0.01 to 0.05 μm.

3. The use according to Claim 1 or Claim 2, wherein the ultra fine silicon oxide powder is amorphous silica.

4. The use according to any preceding Claim, wherein the ultra fine silicon oxide powder is surface-treated with hydrofluoric acid.

5. The use according to any of Claims 1-3, wherein the ultra fine silicon oxide powder is surface-treated with a silane coupling agent.

6. The use according to Claims 1-3, wherein the ultra fine silicon oxide powder is heat-treated at high temperature of not less than 400°C in an inert gas stream.

7. The use according to any preceding Claim, wherein the sealing material comprises 1 to 150 parts by weight of said ultra fine silicon oxide powder based on 100 parts by weight of the crosslinkable elastomer component.

8. The use according to any preceding Claim, wherein the sealing material comprises 0.05 to 10 parts by weight of an organic peroxide, 0.1 to 10 parts by weight of a crosslinking aid and 1 to 150 parts by weight of said ultra fine silicon oxide powder based on 100 parts by weight of the crosslinkable elastomer component.

9. The use according to any preceding Claim, wherein the fluorine-containing elastomer is a perfluoro elastomer.

## Patentansprüche

1. Verwendung eines Dichtungsmaterials zum Abdichten eines Halbleitererzeugungsapparats, gewählt aus einem Ätzsystem, einem Reinigungssystem, einem Belichtungssystem, einem Poliersystem, einem Filmbildungssystem oder einem Diffusions- und Ionenimplantationssystem, wobei das Dichtungsmaterial durch Vernetzung einer vernetzbaren Elastomerzusammensetzung erhältlich ist, umfassend eine vernetzbare fluorhaltige Elastomerkomponente und ein ultrafeines Siliciumoxidpulver, das folgendes aufweist:

   (i) eine Bioctylphthalatadsorption von nicht mehr als 8 μg pro 1 g Siliciumoxid,
   (ii) eine durchschnittliche Teilchengrösse von nicht mehr als 0,5 μm und
   (iii) 100 x $10^{19}$ oder weniger Hydroxylgruppen pro Gramm auf der Pulveroberfläche;

   wobei das Dichtungsmaterial nicht mehr als 1 ppb Dioctylphthalatgas erzeugt, wenn es für 15 Minuten auf 200°C erwärmt wird.

2. Verwendung gemäss Anspruch 1, wobei die durchschnittliche Teilchengrösse des ultrafeinen Siliciumoxidpulvers 0,01 bis 0,05 μm beträgt.

3. Verwendung gemäss Anspruch 1 oder 2, wobei das ultrafeine Siliciumoxidpulver amorphes Siliciumdioxid ist.

4. Verwendung gemäss einem der vorstehenden Ansprüche, wobei das ultrafeine Siliciumoxidpulver mit Flussäure

oberflächenbehandelt ist.

5. Verwendung gemäss einem der Ansprüche 1 bis 3, wobei das ultrafeine Siliciumoxidpulver mit einem Silan-Kupplungsmittel oberflächenbehandelt ist.

6. Verwendung gemäss einem de Ansprüche 1 bis 3, wobei das ultrafeine Siliciumoxidpulver bei hoher Temperatur von nicht weniger als 400°C in einem inerten Gasstrom hitzebehandelt ist.

7. Verwendung gemäss einem der vorstehenden Ansprüche, wobei das Dichtungsmaterial 1 bis 150 Gew.-Teile des ultrafeinen Siliciumoxidpulvers, basierend auf 100 Gew.-Teilen der vernetzbaren Elastomerkomponente, umfasst.

8. Verwendung gemäss einem der vorstehenden Ansprüche, wobei das Dichtungsmaterial 0,05 bis 10 Gew.-Teile eines organischen Peroxids, 0,1 bis 10 Gew.-Teile einer Vernetzungshilfe und 1 bis 150 Gew.-Teile des ultrafeinen Siliciumoxidpulvers, basierend auf 100 Gew.-Teilen der vernetzbaren Elastomerkomponente, umfasst.

9. Verwendung gemäss einem der vorstehenden Ansprüche, wobei das fluorhaltige Elastomer ein Perfluorelastomer ist.

## Revendications

1. Utilisation d'un matériau de scellage pour sceller un appareil de production de semiconducteurs choisi parmi un système de gravage, un système de nettoyage, un système d'exposition, un système de polissage, un système de formation de film ou un système de diffusion et d'implantation ionique, le matériau de scellage pouvant être obtenu en réticulant une composition d'élastomère réticulable comprenant un composant élastomère réticulable contenant du fluor et une poudre ultrafine d'oxyde de silicium ayant :

   (i) une adsorption de phtalate de dioctyle non supérieure à 8 $\mu$g par 1 g d'oxyde de silicium,
   (ii) une taille moyenne de particule non supérieure à 0,5 $\mu$m, et
   (iii) 100 x $10^{19}$ ou moins de groupes hydroxyles par gramme sur la surface de la poudre ;

   ledit matériau de scellage ne générant pas plus d'un 1 ppb de phtalate de dioctyle gazeux lorsqu'il est chauffé à 200 °C pendant 15 minutes.

2. Utilisation selon la revendication 1, dans laquelle la taille moyenne de particule de la poudre ultrafine d'oxyde de silicium est de 0,01 à 0,05 $\mu$m.

3. Utilisation selon la revendication 1 ou la revendication 2, dans laquelle la poudre ultrafine d'oxyde de silicium est de la silice amorphe.

4. Utilisation selon l'une quelconque des revendications précédentes, dans laquelle la poudre ultrafine d'oxyde de silicium est traitée en surface avec de l'acide fluorhydrique.

5. Utilisation selon l'une quelconque des revendications 1 à 3, dans laquelle la poudre ultrafine d'oxyde de silicium est traitée en surface avec un agent de couplage silane.

6. Utilisation selon l'une quelconque des revendications 1 à 3, dans laquelle la poudre ultrafine d'oxyde de silicium est traitée thermiquement à haute température non inférieure à 400 °C dans un courant de gaz inerte.

7. Utilisation selon l'une quelconque des revendications précédentes, dans laquelle le matériau de scellage comprend 1 à 150 parties en poids de ladite poudre ultrafine d'oxyde de silicium sur la base de 100 parties en poids du composant élastomère réticulable.

8. Utilisation selon l'une quelconque des revendications précédentes, dans laquelle le matériau de scellage comprend 0,05 à 10 parties en poids d'un peroxyde organique, 0,1 à 10 parties en poids d'une aide à la réticulation et 1 à 150 parties en poids de ladite poudre ultrafine d'oxyde de silicium sur la base de 100 parties en poids du composant élastomère réticulable.

**9.** Utilisation selon l'une quelconque des revendications précédentes, dans laquelle l'élastomère contenant du fluor est un élastomère perfluoré.